(19) Europäisches Patentamt / European Patent Office / Office européen des brevets

(11) EP 1 829 035 B1

(12) **EUROPEAN PATENT SPECIFICATION**

(45) Date of publication and mention of the grant of the patent:
**21.07.2010 Bulletin 2010/29**

(21) Application number: **05823890.8**

(22) Date of filing: **08.12.2005**

(51) Int Cl.:
***G11B 7/241*** *(2006.01)* ***G11B 7/245*** *(2006.01)*
***G03C 1/73*** *(2006.01)* ***G03F 7/00*** *(2006.01)*
***G11B 7/0065*** *(2006.01)*

(86) International application number:
**PCT/EP2005/056612**

(87) International publication number:
**WO 2006/061419 (15.06.2006 Gazette 2006/24)**

# (54) PHOTOACTIVE FILM, ITS PREPARATION AND USE, AND PREPARATION OF SURFACE RELIEF AND OPTICALLY ANISOTROPIC STRUCTURES BY IRRADIATING SAID FILM

FOTOAKTIVER FILM, SEINE HERSTELLUNG UND VERWENDUNG UND HERSTELLUNG EINES OBERFLÄCHENRELIEFS UND OPTISCH ANISOTROPER STRUKTUREN DURCH BESTRAHLUNG DES FILMS

FILM PHOTOACTIF, SA PREPARATION ET SON UTILISATION, ET PREPARATION DE STRUCTURES ANISOTROPES AU PLAN OPTIQUE ET A RELIEF DE SURFACE PAR IRRADIATION DUDIT FILM

(84) Designated Contracting States:
**AT BE BG CH CY CZ DE DK EE ES FI FR GB GR HU IE IS IT LI LT LU LV MC NL PL PT RO SE SI SK TR**

(30) Priority: **09.12.2004 EP 04029263**

(43) Date of publication of application:
**05.09.2007 Bulletin 2007/36**

(73) Proprietor: **Fraunhofer-Gesellschaft zur Förderung der angewandten Forschung e.V.**
**80686 München (DE)**

(72) Inventors:
- **STUMPE, Joachim**
  **14691 Nauen (DE)**
- **GOLDENBERG, Leonid**
  **13585 Berlin (DE)**
- **KULIKOVSKA, Olga**
  **14165 Berlin (DE)**

(74) Representative: **Leonhard, Frank Reimund et al**
**Leonhard - Olgemöller - Fricke**
**Patentanwälte**
**Postfach 10 09 62**
**80083 München (DE)**

(56) References cited:
**EP-A- 0 555 793** **WO-A-98/36298**

- **NIRMAL K. VISWANATHAN, DONG YU KIM, SHAOPING BIAN, JOHN WILLIAMS, WEI LIU, LIAN LI, JAYANT KUMAR, SUKANT K. TRIPATHY: "Surface relief structures on azo polymer films" J. MATER. CHEM., vol. 9, 1999, - 1999 pages 1941-1955, XP002387957**
- **WANG G ET AL: "Self-assembly and optical properties of poly(acrylic acid)-based azo polyelectrolyte" PREPARATION AND CHARACTERIZATION, ELSEVIER SEQUOIA, NL, vol. 458, no. 1-2, 30 June 2004 (2004-06-30), pages 143-148, XP004510345 ISSN: 0040-6090**
- **UBUKATA T ET AL: "SURFACE RELIEF GRATINGS IN HOST-GUEST SUPRAMOLECULAR MATERIALS" ADVANCED MATERIALS, WILEY VCH, WEINHEIM, DE, vol. 12, no. 22, 16 November 2000 (2000-11-16), pages 1675-1678, XP000976714 ISSN: 0935-9648**
- **SHARMA L ET AL: "INVESTIGATION INTO THE SURFACE RELIEF GRATING MECHANISM VIA XPS IN NEW AZOBENZENE BASED OPTICAL MATERIAL" POLYMERS FOR ADVANCED TECHNOLOGIES, WILEY & SONS, BOGNOR REGIS, GB, vol. 13, no. 6, June 2002 (2002-06), pages 481-486, XP001112859 ISSN: 1042-7147**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

• **PATENT ABSTRACTS OF JAPAN vol. 2000, no. 17, 5 June 2001 (2001-06-05) & JP 07 299963 A (CHEIL SYNTHETICS INC), 14 November 1995 (1995-11-14)**

## Description

The present invention relates generally to a new type of film forming material having unique photochemical properties. Non-scattering, optically clear films formed from the new materials can be easily prepared. They allow light-induced generation of optical anisotropy (photo-induced dichroism and birefringence) therein and of topological surface structures, e.g. such as surface relief gratings (SRG). The material comprises or consists of a charged polymer with photosensitive, side groups having the ability to undergo E/Z isomerisation or to participate in a light induced cycloaddition or in a photoinduced rearrangement reaction or another reaction capable of generating optical anisotropy in the material upon irradiation. The material readily forms films, preferably on solid substrates or between two such substrates from water/alcoholic or organic solvents.

It is known that amorphous and liquid crystalline polymers containing azobenzene or other photoactive moieties such as stilbenes, cinnamates, coumarins in side chains or main chains can be used for the induction of anisotropy by photoorientation (K.Ichimura, Chem. Rev. 2000, 100, 1847; A. Natansohn et al., Chem. Rev. 2002, 102, 4139; V. Shibaev et al., Prog. Polym. Sci. 28 (2003) 729-836; X. Jiang, et al., WO 98/36298). Azobenzene derivatives are also known for their ability to form SRG when being exposed to gradient light field (A. Natansohn et al., supra).

Different types of azobenzene containing materials were used for optical anisotropy and/or SRG generation. In one approach ("guest-host" systems), this was attained by mixing of photochromic azobenzene derivatives, e.g. 4-[4-N-n-hexyl-N-methylaminophenylazo]-benzoic acid or modified Direct Red 1 azodye with readily available polymer PMMA as a matrix (J. Si et al., APPL. PHYS. LETT. 80, 2000, 359; C. Fiorini et al., Synthetic Metals 115 (2000), 121-125). However, the effects to be observed are rather weak, due to low dye loading caused by dye-polymer segregation. Relatively high loading of the photochromic material in the polymer matrix could be observed with specially synthesized dyes, which allow avoiding a dye-polymer segregation (C. Fiorini et al., see above). But in such systems the photoinduced dichroism was not stable, and the SRG formation was not effective (up to 50 nm deep). Relatively stable birefringence has been induced only when commercially available Direct Red 1 was introduced into very high-$T_g$ poly(ether ketone). It is unknown whether SRGs can be generated in the latter system. Such materials were used for the recording of orientational holograms. Better results have been obtained by chemically binding azodye compounds to a polymeric material. The material is characterized by covalent bonds between the photoactive units and the polymeric backbone. In addition to the fact that the results observed are much better than in the "guest-host" approach, such polymer materials normally have good film forming properties. However, environmentally non-friendly organic solvents have to be used. Often the solubility of the polymers is a problem which is hardly to overcome. Special synthesis is required to manufacture such functional polymers from commercially available chemicals, and consequently, they are expensive. Moreover, the purification of the polymers is a difficult problem as well.

Recently, a specially synthesized monomeric azobenzene derivative has been found which is able to form glassy films (V. Chigrinov et al., 1106 • SID 02 DIGEST; V.A. Konovalov, et al., EURODISPLAY 2002, 529; W.C.Yip et al., Displays, 22, 2001, 27). In films of these low molecular weight glass forming compounds optical anisotropy was induced by irradiation with linearly polarised light.

Moreover, a layer-by-layer (LBL) dipping procedure has been employed to obtain films for photo-induced orientation and SRG formation (see e.g. A. M.-K. Park et al, Langmuir 2002, 18, 4532; Ziegler et al., Colloids and Surfaces, A 198-200 (2002), 777-784; V. Zucolotto et al., Polymer 44 (2003), 6129-6133). In such systems, readily available polyelectrolytes and low molecular weight azodyes possessing at least two ionic groups, azobenzene containing bolaamphiphiles, ionenes or polyelectrolytes covalently substituted with azobenzene moieties are used. In the typical procedure, a substrate is alternately immersed for about 10-20 min in an aqueous solution of a cationic polyelectrolyte, such as poly-DADMAC, and an anionic azobenzene containing compound, respectively. Each immersion results in the formation of a monolayer on the substrate surface with typical thickness of about 1 nm. Numerous repetition of this procedure results in a multilayer film. About 150 layers are required to obtain a reasonable thickness of the resulting layer. Films up to 700 layers can be produced. SRGs with an amplitude of up to 120-140 nm can be generated, wherein a photoinduced orientation of the azobenzene moieties can be observed. The procedure is tedious and time consuming. Moreover, rather thick films are necessary for the inscription of deep SRG, and such films are difficult to obtain.

N.K. Viswanathan et al., Surface relief structures on azo polymer films, J. Mater. Chem., 1999, 9, 1941-55, gives an overview over the fabrication of Surface Relief Grating (SRG) on azobenzene functionalized polymer films of that time. Side chain azo polymers, prepared by post-coupling reaction, are described. Upon ionization, azo polyions may result which, along with an oppositely charged polyelectrolyte, could be assembled into multilayer films.

Likewise, a multilayer can be prepared from a poly(acrylic acid)- based azo polyelectrolyte and poly(dialkyl-dimethylammonium chloride), using an electrostatic layer-by-layer deposition process, as outlined in G. Wang et al., Thin Solid Films 458 (2004) 143-148.

Another approach using H-bonds between the polymeric backbone and the photochromic compounds has been employed (E.B. Barmatov et al., Polymer Science, Ser. A, Vol 43 (3), 2001, 285). In this way, films with the ability for photoorientation were obtained.

In these concepts, the components are bound to each other by Coulomb attraction or H-bonds. Similar attraction is possible between oppositely charged ionic moieties in solution. The interaction of polyelectrolytes with dyes in dilute solutions has been studied (W. Dawydoff et al., Acta Polym. 1991, 42, 592). Recently, complexes of polyelectrolytes with another, oppositely charged polyelectrolyte containing a diazosulfonato moiety in the side chain were fabricated as a solid material (A.F. Thunemann et al., Macromolecules 1999, 32, 7414; 2000, 33, 5665). The molecular photochemistry and light-induced subsequent physical processes of these materials such as photoorientation and photo-induced diffusion, were not investigated.

In summary, a multiplicity of chemical systems making use of the photochemical properties of photochromic azobenzene dyes has been developed during the past few years. Such compositions may form films, which allow introduction of optical anisotropy and/or the generation of surface relief structures therein. However, despite the intense search for effective and readily available compositions, they are all connected with certain disadvantages as outlined above.

The inventors found that a material having the below chemical properties can be used as the or part of the material for a photoactive film combining high efficiency of the induction of optical anisotropy as well as of surface relief structures with the simplicity of material preparation. The material consists of or comprises a polymer with photosensitive, charged side groups having the ability to undergo E/Z isomerisation or to participate in a light induced cycloaddition or in a photoinduced rearrangement reaction or the like. Further components such as plasticizers, conventional organic oligomers or polymers, other photosensitive compounds, dyes, or liquid crystalline compounds can be added to modify formulation properties, and the properties of the films (flexibility of the film, hydrophilic/hydrophobic properties and the like). The said materials readily form films on solid substrates from water/alcoholic or organic solvents. Optical anisotropy and/or surface relief structures can be induced in these films upon irradiation with light.

The photosensitive polymer suitable for the present invention is a polyelectrolyte the charged side chains of which are capable to undergo a photoreaction, mainly selected from photoisomerization, photocycloaddition reactions and photoinduced rearrangements. If they are capable to undergo a photoisomerization, the polymer substantially consists of or mainly comprises a structure according to formula I or II

$$[Pol(R^{*}\text{-}P\text{-}R')]_o^{on+}\ n o/x\ A^{x-}\ (I),$$

or

$$no/x\ A^{x+}\ [Pol(R^{*}\text{-}P\text{-}R')]_o^{on-}\ (II),$$

wherein Pol means a repeating unit of a linear or branched polymer chain of the polyelectrolyte, o indicates the number of the repeating unit in the polyelectrolyte and ($R^*$-P-R') and ($R^{1*}$-Q-$R^{1'}$) are n-fold positively or negatively charged side chains of the repeating unit Pol, whereby

P is a group which is capable to undergo photo-induced E/Z isomerization,

R* is selected from optionally substituted and/or functionalized aryl-containing groups bound to the repeating unit Pol and to group P,

R' is selected from optionally substituted and/or functionalized aryl-containing groups, wherein at least one of R* and R' is positively or negatively charged,

A is a cation or anion which is oppositely charged,

n is preferably 1 or 2, more preferably 1, but may in specific cases be higher (3 or 4),

x is 1 or 2, and

o is at least 2, preferably between 2 and 1000, but can be even higher.

Preferably, P is an azo group -N=N-, or comprises more than one such group. However, the invention is not restricted to compounds of formulae I or II containing one or more azo groups. For example, P may be -C=N- or, -C=C-. It is preferred in any of the mentioned cases that at least one, or preferred both of the aryl moieties are directly bound to the group P.

If the polyelectrolyte side chains are capable to undergo a photocycloaddition or photoinduced rearrangement, the polymer substantially consists of or mainly comprises a structure according to formula III or IV:

$$[Pol(R^{1*}\text{-}Q\text{-}R^{1'})]_o^{on+}\ no/x\ A^{x-}\ (III),$$

or

$$no/x\ A^{x+}\ [Pol(R^{1*}\text{-}Q\text{-}R^{1'})]_o^{on-}\qquad (IV)$$

wherein

Q is a group capable of participating in a photocycloaddition, preferably a (2+2) addition or a (4+4) addition, or capable of participating in a photoinduced rearrangement, preferably the rearrangement of spiropyranes to merocyanines, or the so called Photo-Fries reaction,

$R^{1*}$ is selected from optionally substituted or functionalized groups which have electron-accepting properties and is bound to the repeating unit Pol and to group Q,

$R^{1'}$ is selected from optionally substituted or functionalized groups which have electron-accepting properties or comprise at least one aryl moiety or such (a) group(s)

which together with Q form an aryl ring or heteroaryl ring, wherein at least one of $R^{1*}$ and $R^{1'}$ is positively or negatively charged, or wherein the ring structure comprising $R^{1'}$ and Q and/or a substituent thereon will carry at least one positive or negative charge,
and A, n, and x are defined as for formulae (I) and (II) above.

In case the photocycloaddition is a (2+2) addition, Q will preferably contain a -C=C- or a -C=N- bond and will more preferably consist of the group $-CR^2=CR^{2'}-$ or $-CR^2=N-$wherein $R^2$ and $R^{2'}$ are independently selected under H or a $C_1$-$C_4$ group. Preferably, Q is part of a conjugated p$\pi$-electron system. Examples for respective compounds are cinnamates, imines, stilbenes, chalcones, or p-phenylene diacrylic esters or amides, wherein at least one of $R^1$ and $R^{1'}$ is an optionally substituted or functionalized phenyl or other aryl or heteroaryl ring and the other is also an optionally substituted or functionalized phenyl or other aryl or heteroaryl ring or a carboxylic ester or carbonamide group or a phenyl carbonyl residue. All the said groups or residues may be substituted or functionalized, and at least one of $R^1$ and $R^{1'}$ must carry at least one positive or negative charge. Alternatively, Q may be a -C=C- group which is part of a carbocyclic or heterocyclic, preferably aromatic ring, e.g. in coumarins, in thymine or cytosine derivatives or in maleinic acid anhydride derivatives. According to the above definition, $R^1$ and $R^{1'}$ are in such cases fused to form a ring structure, together with Q. One or more atoms of this ring structure or, alternatively, a substituent attached thereto may carry the respective at least one positive or negative charge. Again, such compounds, if carrying at least one positive or negative charge, will fall under the scope of the present invention.

In specific cases, when the photocycloaddition is not a (2+2) cycloaddition, Q may comprise more atoms in its backbone and may e.g. be an aromatic $C_6$ ring which can be fused within an aromatic system or may carry suitable residues at least one of which carries the respective charge(s). One example is an anthracene derivative. Anthracenes are known to undergo a (4+4) cycloaddition whereby carbon atoms 9 and 10 will form bridges to a neighbour atom, resulting in formation of a sandwich-like dimer structure.

Polymers having structures (I) to (IV) may carry more than one photosensitive group per side chain. For example, the side chains of said polymers may include bisazobenzene or trisazobenzene groups as well as diacrylic ester compounds, e.g. p-phenylene-diacrylic esters.

If R*, R', $R^{1*}$ and/or $R^{1'}$ is an aryl or aryl containing group, it may be or may comprise a homocyclic or heterocyclic ring. Optionally, this ring may be fused to an aromatic system, e.g. a naphthalene or anthracene system. Further, the ring can be substituted or functionalized by one or more substituents.

In the definitions given above, the term "functionalized" shall mean substituted by a substituent which implies an additional functionality to the molecule, e.g. a substituent carrying a charge, like a $SO_3H$ group, or a substituent which can provide the capability of polymerization or polyaddition, e.g. a S-H group, or a polymerizable -C=C-group. The term "substituted" shall mean any other substituent.

The compounds as defined above may be used in any kind of salts as available, e.g. ammonium or sodium salts, chlorides, sulfates and the like, or they may be acidic or basic compounds e.g. carboxylic acids, sulfonic acids, amines, or a hydroxy group carrying compounds, and the like, which are capable of reacting with an oppositely charged polyelectrolyte to yield a respective ionic complex. As outlined above, they can be positively or negatively charged, with one or more charges.

Pol can for example be an optionally substituted polyalkylenic unit, preferably a $C_2$-$C_6$ polyalkylene unit, for example an ethylenic unit $-CH_2-CH_2-$, wherein one of the carbon-bound hydrogen atoms is replaced by R* or $R^{1*}$. Instead, Pol may comprise or consist of an alkyleneoxide or alkylenamine, preferably a $C_2$-$C_6$ alkyleneoxide or alkyleneamine, e.g. $-CH_2-CH_2-O-$, or-$CH_2-CH_2-NH-$, wherein one of the hydrogen atoms bound to C or N is replaced by R* or $R^{1*}$. R* and $R^{1*}$ can be bound to Pol either via carbon-carbon bonds, but also by way of an ether, ester, amine, amide, urea, guanidino, or sulfonamido or a comparable group. Attachment via a sulfonamido group is preferred; its orientation such that the amino group is bound to Pol is most preferred. In the above mentioned embodiments of Pol, it itself is not charged, which means that the charges are on the groups (R*-P-R') or ($R^{1*}$-Q-$R^{1'}$), respectively. The structures can then be defined to be

$$[Pol(R^*\text{-}P\text{-}R'^{n+})]_o\ n o/x\ A^{x-}\ (I'),$$

or

$$n o/x\ A^{x+}\ [Pol(R^*\text{-}P\text{-}R'^{n-})]_o\ (II'),$$

or

$$[Pol(R^{1*}\text{-}Q\text{-}R^{1'n+})]_o\ n o/x\ A^{x-}\ (III'),$$

or

$$n o/x\ A^{x+}\ [Pol(R^{1*}\text{-}Q\text{-}R^{1'n-})]_o\ (IV')$$

Alternatively, units Pol are charged themselves, e.g. may carry an alkylsulfonate group or alkylammonium group or the like, while the groups (R*-P-R') and ($R^{1*}$-Q-

$R^{1'}$), respectively, are also charged or are uncharged.

The expression "essentially consisting", used in connection with the above structures (I) to (IV) shall mean that the said structures constitute the main body of the polyelectrolyte. Of course, a unit $[Pol(R^*\text{-}P\text{-}R')^{n+}]$ or any other of the above mentioned units (I) to (IV) cannot exist at the beginning and at the end of the polymer chain, and it is to be understood that the said units will carry an additional substituent, in most cases hydrogen, or eventually an alkyl group (e.g. $C_1$-$C_4$) bound to Pol. The polyelectrolyte of the present invention may be a homopolymer, i.e. comprising immediately subsequent units of Pol. Alternatively, it may consist of a copolymer (statistic or graft copolymer). In this connection, the expression "mainly comprising" shall mean that the chain of "Pol" units can be interrupted and/or that up to half the units (in terms of weight and/or of number) may be replaced by other 2-binding groups, e.g. Pol units which do not carry any of the above defined P or Y containing, photosensitive side chains, or other copolymerizing units, which carry no or other functional or non-functional groups, e.g. carbonic acid or ester groups, ethylenically unsaturated groups, or the like. In other cases, one or more unit $[Pol(R^*\text{-}P\text{-}R')^{n+}]$ or any other of the above mentioned units (Ia) to (IVa) may be replaced by a trivalent unit in order to obtain a branched second electrolyte.

In order to obtain the material of the present invention, the photosensitive polyelectrolyte as defined above is dissolved in a suitable solvent. Since the polyelectrolyte is ionic, it is usually soluble in protic and polar solvents, in most cases in water or a lower alcohol or a mixture of both. The solution is preferably considerably concentrated, often up to saturation. Additives may be incorporated at any stage prior to forming the films, as appropriate. They may either be added to the solution or may be added to the polyelectrolyte of the invention in any stage. Additives may be, for example, organic polymers, compounds having film forming abilities, plasticizers, liquid crystals and/or other, e.g. monomer, low molecular photosensitive compounds

The polyelectrolyte according to the present invention is rather stable, due to its ionic character. Specifically, it will be resistant against the influence of heat in a much larger extent than comparable materials which are not of ionic nature. Such materials will in general soften at lower temperatures.

In a specific embodiment of the invention, the materials of the present invention comprise the photosensitive polyelectrolyte, together with one or more additional components which may undergo or provide cross-linking of the film, preferably after structurization. Such components may be selected from additional organic monomers which are capable to bind to specific groups of the polyelectrolyte, forming bridges and/or an organic network. In one embodiment, this component is selected from monomeric photosensitive molecules which are capable to undergo photopolymerisation or photo-crosslinking. Preferably, the conditions of photopolymerisation or crosslinking should be such that a wavelength is used which is different from that used for "recording" (SRG formation) as mentioned above. In another embodiment, this component is susceptible to thermal curing or polymerizes/provides bridges or a crosslinking network upon thermal treatment.

Depending on the solvent, any of the conventional film forming techniques like spin-coating or casting, doctor's blading and the like can be used to prepare homogeneous films on a substrate in merely one step. In addition, ink-jet printing to produce patterned films, is also readily available using e.g. water/alcoholic media. After the film has been deposited on the substrate or the respective basic layer, it is allowed to dry, preferably at room temperature, for example in air.

The thickness of the films may vary in a broad range, depending on the desired application. For example, it may vary between 10 nm and 50 $\mu$m, typically between 200 nm and 5 $\mu$m. If desired, additional layers may be deposited, either between the substrate and the film of the inventive photosensitive material and/or as one or more covering layers on the upper surface of the film.

The photoactive material according to the invention is light-sensitive, due to the presence of groups in the polyelectrolyte which may either undergo light-induced E/Z isomerization and/or photocycloaddition reactions, or light induced rearrangement reactions. Under homogeneous irradiation with polarized actinic light, optical anisotropy is induced within films made from this material. The optical anisotropy may be stable, unstable or erasable in dependence on the material composition, treatment and irradiation conditions, as outlined below. Under inhomogeneous irradiation, both a modulation of optical anisotropy and a deformation of film surface may be achieved. Most surprisingly, the latter process is as effective or even more effective as reported for azobenzene containing functionalized polymers that have been known as the most effective for the surface relief gratings formation. In this regard the material of the present invention is a viable alternative to the covalently bonded polymer systems used until now.

As mentioned above, the properties of the proposed material may be optically modified in different ways. If irradiated homogeneously with polarized light, the film becomes anisotropic, that means, birefringence and/or dichroism are induced. This is due to a photoorientation process in the steady state of the photoisomerization in the material upon polarized irradiation. For example, if the material contains groups which undergo E/Z isomerization, light irradiation will result in an orientation of such groups. In case of photocycloadditions or other photoreactions, an angular-selective photo-decomposition or angular-selective formation of photoproducts will be observed.

The optical anisotropy induced in such a way may relax back, be erased thermally or by irradiation with light, or may be stable. For example since Z isomers relax

back to the thermodynamic stable E isomers, the induced orientation based on the E/Z isomerization may be stable, may undergo relaxation, or may be erased thermally or photochemically. Thus, the optical anisotropy of azobenzene systems is only temporary induced (while surface relief gratings formed therewith are long-term stable, see below). However, optical anisotropy and surface gratings due to photocycloaddition will remain stable since the reaction is not reversible. Stability of optical anisotropy may also be achieved by using a material which allows further curing or crosslinking, e.g. by building up an organic network within the film. In such cases, light induced optical anisotropy may be "frozen" in the material when the material is cured after inducing said anisotropy.

The velocity of the induction and relaxation processes, if any, may be controlled through adjusting the temperature and/or the parameters of irradiating/ erasing light. In this way a variety of thin film polarization elements like polarizer or retarder may be created that may be permanent or optically switchable. The light-induced change of birefringence or dichroism in this material may be also effectively used for optical data storage and, if reversible, for optical processing.

If a film is irradiated with an inhomogeneous light field, i.e. a light field wherein the intensity or/and polarization of irradiating light is spatially modulated, the induced anisotropy is correspondingly modulated through the film. One example of this is irradiation through a mask. In this way, pixel thin film polarization elements may be fabricated. Another example is irradiation with an interference pattern, i.e. holographic irradiation. In this way, a variety of holographic optical elements operating in transmission or reflection modes (like polarization beam splitter or polarization discriminator) may be realized.

Moreover, surface relief structures may be generated on the free surface of films made from the material of the present invention by inhomogeneous irradiation with polarized light (holographic, mask or near-field exposure). Surface relief structures may be a result of a photo-induced mass transport upon an E/Z photoisomerization reaction or upon photocycloaddition or photoinduced rearrangement reaction (e.g. caused by shrinkage due to ring formation).

If a film made of the material of the present invention is irradiated inhomogeneously, formation of surface relief structures (surface relief gratings, SRGs) can be observed along with the generation of inhomogeneous optical anisotropy. However, formation of SRGs can, if required or desired, be suppressed by irradiating a film between two substrates. In respect to reversibility and irreversibility of surface relief structures, the same applies as outlined above for the occurrence of optical anisotropy.

The lateral size of generated relief structures ranges from tens of nanometers (in the case of irradiation with near-field) up to the dimension of micrometers provided by holographic irradiation. It is being demonstrated here that the efficiency of the relief formation is comparable to the values reported for the azobenzene functionalized polymers (modulation depth of 0.6 μm was achieved in first, not yet optimized tests). Atomic force microscopy (AFM) images of SRG written in the materials of the present invention and, for comparison, in side chain azobenzene polymers of the prior art are shown in Fig. 1.

There are unique possibilities of the material application, due to the reversibility of the recording process, if a material is selected which allows reversible formation of surface relief structures. Once a relief structure has been recorded, it may be overwritten again. This allows the recording of complicated surface structures by superimposing their simple components. In this way, for example, multidimensional structures may be realized by successive recordings of simple one-dimensional structures; gratings with non-sinusoidal profile may be formed by successive recording of Fourier components or any recorded structure may be in a point way corrected. Another benefit of the reversibility of the process is the possibility of multiple use of the film. A high number of writing cycles without fatigue is possible. On the other hand, if generated in the material with additive as described above, the final relief structure may be "frozen" or fixed, for example, thermally or by flood exposure (exposure of the whole film) in order to obtain cross linking or the like and to avoid destruction of the resulting relief.

In this way a variety of relief holographic elements like diffraction grating, beam coupler, beam multiplexer, splitter or deflector, Fresnel lens and the like may be created. Applications of structured films (in particular gratings) are not restricted to optical elements only. One step all-optical structured surfaces may be used as templates for self-organisation of particles, as command surface for alignment of liquid crystals, as surface with modified wetting/dewetting properties or as antireflective layers.

If surface relief structures have been prepared according to the invention, such structures may be replicated using a wide variety of different materials. Replication may be performed once or manifold. A replica may again serve as template for replication. Materials which are useful for replication are known in the art. Examples are polysiloxanes, e.g. polydimethylsiloxane. Such materials may be prepared as resins having sufficiently low viscosity to fill the fine structures of the SRG and may be dried or cured after replication to yield a stable material. Other examples are polyacrylate resins, polyurethanes, ene-thiol compositions or a metal, e.g. via electrochemical deposition from a metal solution. The initial surface relief structure can be washed out from the replica, if desired, using an appropriate solvent.

The materials of the present invention have, inter alia, the following advantages: they can be manufactured from readily available non-expensive commercial materials, namely commercially available polyelectrolytes and photochromic derivatives with ionic groups. There is a great flexibility in their preparation, as well as

in the composition of the materials and systems (multicomponent systems). It is possible to use environmental friendly water/alcoholic media as solvents. Since the complexes and formulations are prepared in protic solvents like water and/or alcoholic media, films can easily be prepared on polymeric or other (e.g. inorganic) substrates or combined with other polymer layers which are not stable in organic solvents usually used for polymer film manufacturing, but would allow to form another layer from water/alcoholic media. Ink-jet printing will be also readily available with water/alcoholic solvents. In case of a replication of SRGs and other topological surface structures using other polymer or non-polymer material, the initial photosensitive film with the photo-induced structure can be washed out by solvents. Anisotropic films and surface relief structures can be produced using the new material without expensive synthesis and purification of photochromic polymers wherein the photochromic unit must be covalently attached to the polymer backbone. And due to the ionic nature of the using materials, the film and products made from this film, e.g. SRGs, are thermally stable, at least until about 150 to 200°C.

Due to their superior chemical and physical (optical, mechanical) properties, the material of the present invention may be used in a wide variety of technical fields, and specifically in the field of technical and other optics, data storage and telecommunication. For example, the material may be used as a photosensitive medium, optical element, functional surface and/or template. Said elements may e.g. be diffractive elements, polarization elements, focusing elements or combinations of such elements. If the light-induced properties thereof are reversible, they can be used as or in elements for optical or optical/thermal switching. In such cases, the material is preferably prepared by a method as claimed in claim 27 or 28. Further, if the light-induced properties are reversible, it may be used as a medium for real-time holography or optical information processing. Alternatively, the photosensitive medium can be a medium for irreversible or reversible optical data storage. If the data storage is reversible, written information can subsequently be eliminated by irradiation or heating, if desired, whereafter another writing cycle is possible. In other applications, the material is used as a template, wherein the template surface is a surface for replication to another material or the command surface for aligning of liquid crystals, self-organization of particles. The surface may determine the chemical, mechanical and/or optical properties of the material, preferably selected from wetting/dewetting, hardness, reflectance and scattering.

Figures 1 are AFM images of SRG written in material of the present invention (Figure 1a, Example 1) and in poly((4-(4-trifluoromethylphenylazophenyl- 4-oxy)butyl)methacrylate)-co-poly((2-(4-cyanobiphenyl-4- oxy)ethyl) methacrylate) (Fig. 1b, Example 2).

Figure 2 illustrates the intensity of the orthogonally polarised components of the transmitted probe beam and switching between two states under alternating irradiation (measurements on the material of Example 2 in Figure 1 b).

Figure 3 is a polar diagram of absorption at 500 nm versus angle of polarization of the same material.

Figure 4 illustrates kinetics of the diffracted probe beam during SRG writing into said material.

Figure 5 illustrates total DE (different polarization of probe beam) and relief amplitude for orientation grating inscribed according to Example 3.

Below, the invention shall be exemplified further.

**Example 1.**

"Recording".

A film of about 2.5 μm thickness was prepared by casting the solution of 30 mg of poly{1-[4-(3-carboxy-4- hydroxyphenylazo) benzenesulfonamido]- 1,2- ethanediyl, sodium salt} (PAZO) (Aldrich) in 1 ml of MeOH onto the glass substrate in a close chamber at room temperature. After drying at room temperature in air for 20 h the film was irradiated for 2 h with the interference pattern formed by two linearly orthogonally polarized beams with polarization planes at ±45° to the incidence plane. The irradiation wavelength was 488 nm, and the angle between beams was about of 12° resulting in a period of 2.3 μm. The intensities of interfering beams were equal to 250 mW/cm$^2$, the irradiation time was 40 min. The 1$^{st}$ order diffraction efficiency of the SRG recorded was measured to be 35%, the kinetics of recording is illustrated in the Figure 4. AFM image is shown in the Figure 1a.

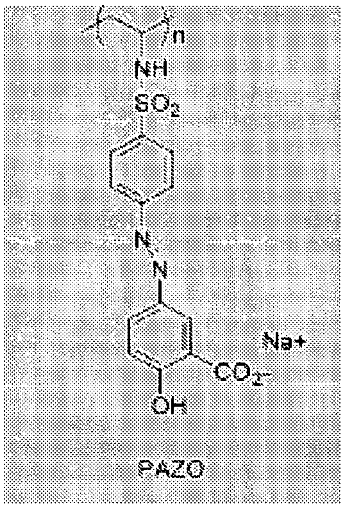

PAZO

### Example 2.

"Photoinduced Anisotropy".

A film of about 2.5 μm thickness was prepared by casting the solution of 30 mg of poly{1-[4-(3-carboxy-4- hydroxyphenylazo) benzenesulfonamido]- 1,2- ethanediyl, sodium salt} (PAZO) (Aldrich) in 1 ml of MeOH onto the glass substrate in a close chamber at room temperature. After drying at room temperature in air for 20 h the film was irradiated by linearly polarised light of 488 nm and 250 mW/$cm^2$ for 1 h. Induced birefringence was stable, but could be erased by the light of proper polarization and induced again in any other direction (Figure 2). The induced anisotropy was investigated by polarised UV-vis spectroscopy (Figure 3, polar diagram). The value of optical dichroism has been found at 500 nm to be D=0,19.

### Example 3.

Orientation grating recording.

A film of about 2.5 μm thickness was prepared by casting the solution of 30 mg of poly{1-[4-(3-carboxy-4- hydroxyphenylazo) benzenesulfonamido]- 1,2- ethanediyl, sodium salt} (PAZO) (Aldrich) in 1 ml of MeOH onto a glass substrate in a close chamber at room temperature. After drying at room temperature in air for 20 h the film was irradiated for 20 min with the interference pattern formed by two circularly orthogonally polarized beams. The irradiation wavelength was 488 nm, and the angle between beams was about of 12° resulting in a period of 2.3 μm. The intensities of interfering beams were equal to 250 mW/$cm^2$. The total diffraction efficiency of the SRG recorded was measured to be up to 55 % (confer to Figure 5).

Figure 5 displays the total DE (different polarization of probe beam) and relief amplitude for orientation grating inscribed in Example 3.

### Example 4.

Stability of orientation grating.

Orientation grating was written as described in example 3 for 5 min. After relaxation grating lost only 40 % of DE. Annealing at 100°C for 1 h did not lead to any loss of DE.

### Example 5.

Surface relief grating stability.

SRG was written as described in example 1. Annealing of the film with the inscribed SRG at temperature of about 200°C did not change the depth of the grating. No appreciable decrease in the DE was observed during heating at 200°C for at least 6 h.

## Claims

**1.** Homogeneous, photoactive film of a materials consisting of or comprising a polyelectrolyte carrying residues which may undergo a photoreaction, selected from photoisomerizations, photocycloadditions and photoinduced rearrangements, the polyelectrolyte essentially consisting of or mainly comprising at least one structure according to formula I or formula II

$$[Pol(R^*\text{-}P\text{-}R')]_o^{on+}\ n/x\ A^{x-}\quad (I),$$

or

$$n/x\ A^{x+}\ [Pol(R^*\text{-}P\text{-}R')]_o^{on-}\quad (II),$$

and/or of formula III or IV:

$$[Pol(R^{1*}\text{-}Q\text{-}R^{1'})]_o^{on+}\ n/x\ A^{x-}\quad (III),$$

or

$$n/x\ A^{x+}\ [Pol(R^{1*}\text{-}Q\text{-}R^{1'})]_o^{on-}\quad (IV)$$

wherein Pol means a repeating unit of a linear or branched polymer chain, o indicates the number of the repeating unit of the polymer chain, and ($R^*$-P-R') and ($R^{1*}$-Q-$R^{1'}$) are n-fold positively or negatively charged side chains of the repeating unit

Pol wherein
P is a group which is capable of photo-induced E/Z isomerization,
$R^*$ is selected from optionally substituted and/or functionalized aryl-containing groups bound to the repeating unit Pol and to group P,
R' is selected from optionally substituted and/or functionalized aryl-containing groups,
wherein at least one of $R^*$ and R' is positively or negatively charged,
Q is a group capable of participating in a photocycloaddition, or capable of participating in a photoinduced rearrangement, or the so called Photo-Fries reaction,
$R^{1*}$ is selected from optionally substituted or functionalized groups which have electron-accepting properties and is bound to the repeating unit Pol and to group Q,
$R^{1'}$ is selected from optionally substituted or functionalized groups which have electron-accepting properties or comprise at least one aryl moiety or such (a) group(s) which together with Q form an aryl ring or heteroaryl ring,
wherein at least one of $R^{1*}$ and $R^{1'}$ is positively or negatively charged, or wherein the ring structure comprising $R^{1'}$ and Q and/or a substituent thereon will carry at least one positive or negative charge,
A is a cation or anion which is oppositely charged,
n is 1, 2, 3, or 4,
x is 1 or 2, and
o is at least 2,
with the proviso that in one polyelectrolyte, groups Pol and/or [R-P-R'] and/or [$R^1$-Q-$R^{1'}$] all have the same sign,
wherein the homogenous film has a thickness of at least 10nm.

2. Film according to claim 1, wherein the structures (I) to (IV) are of formulae

$$[Pol(R^*\text{-}P\text{-}R'^{n+})]_o\ n/x\ A^{x-}\ (I'),$$

or

$$n/x\ A^{x+}\ [Pol(R^*\text{-}P\text{-}R'^{n-})]_o\ (II'),$$

or

$$[Pol(R^{1*}\text{-}Q\text{-}R^{1'n+})]_o\ n/x\ A^{x-}\ \ (III'),$$

or

$$n/x\ A^{x-}\ \ [Pol(R^{1*}\text{-}Q\text{-}R^{1'n-})]_o\qquad (IV')$$

3. Film according to claim 1 or 2, wherein group P and group Q in formulae (I) to (IV) are selected from -N=N-, -$CR^2$=$CR^{2'}$- with $R^2$ , $R^{2'}$ being independently selected from H, CN or $C_1$-$C_4$ alkyl, and a group containing more than one -N=N- and/or -$CR^2$=$CR^{2'}$- moieties in a electron-conjugated system.

4. Film according to any of claims 1 to 3, wherein in formulae (I) or (II), the aryl moieties of R, R are directly bound to the group P, and/or wherein in formulae (III) or (IV), $R^1$ and $R^{1'}$ are selected from aryl moieties directly attached to Q, and -C(O)O- and -(CO)$NR^3$ groups wherein $R^3$ is H or a optionally substituted alkyl or aryl group.

5. Film according to any of claims 1 to 3, wherein the side chains of the polyelectrolyte are selected from monoazo groups, bisazo groups, trisazo groups, and preferably from azobenzene groups, bisazobenzene groups, trisazobenzene groups, and further from stilbene groups, cinnamate groups, imines, anthracene groups, coumarine groups, chalcone groups, p-phenylene diacrylates or diacrylamides, thymin derivatives, cytosine derivatives, merocyanines/spiropyranes and groups containing maleinic acid anhydride.

6. Film according to any of claims 1 to 5, wherein $R^*$ and $R^{1*}$ are bound to the monomer units Pol via a carbon-carbon bond, or by way of an ether, ester, amine, amide, urea, guanidino, or sulfonamido group.

7. Film according to any of claims 1 to 6, comprising at least one additive which modifies the properties of the material, preferably selected from organic polymers, compounds which have film forming abilities, plasticizers, liquid crystals and photosensitive compounds differing from those as defined in claim 1.

8. Film according to claim 7, the film material additionally comprising a monomeric photosensitive molecule, which is capable to undergo polymerisation or to provide cross-linking, induced either by irradiation with light or by thermal treatment.

9. Film according to any of the preceding claims, wherein the film formation was carried out from an environmentally friendly solvent such as water-alcohol solution.

10. Film according to any of the preceding claims, wherein stacks of films were prepared from the said material and an additional polymer material soluble

in organic solvent, but not soluble in water-alcohol solution to allow laminating the orientational and the surface relief structures by the additional polymer material to prevent the active layer and for preparing multifunctional stacks based on materials with different functions.

**11.** Film according to any of the preceding claims, either being placed as a layer on a substrate or in the form of a free-standing film, the film optionally being patterned.

**12.** Film according to any of the preceding claims, wherein at least one optical property of the film, preferably selected from refraction, absorption, birefringence, dichroism or gyrotropy, has been changed upon irradiation with light.

**13.** Film according to claim 12, wherein the changing optical properties are either

a. homogeneous through the material or
b. varied through the material or through restricted areas thereof.

**14.** Film according to claim 13, variant (b), wherein optical properties are modulated in one, two or three dimensions including modulation in the direction perpendicular to the film plane, in any direction in the film plane or along the axis tilted to the film plane.

**15.** Film according to any of the preceding claims wherein the film is placed on a substrate or is a free-standing film, at least one free surface of which exhibits a light-induced relief structure.

**16.** Film according to claim 15, wherein the relief structure is a regular pattern with height modulated in one or two dimensions.

**17.** Film according to claims 12 to 16, wherein the induced changes of optical properties or/and the induced relief structure are either

a. reversible or
b. irreversible.

**18.** Film according to claim 17, variant (a), wherein the changes of optical properties or/and of the relief structure are stable when kept at day light below the glass transition temperature or the decomposition temperature.

**19.** Film according to claims 17, variant (a), and 18, wherein the changes of optical properties or/and of the relief structure are cyclically induced with light and erased optically or thermally.

**20.** Method for the preparation of a film according to any of claims 1 to 11, comprising dissolving a polyelectrolyte essentially consisting of or mainly comprising at least one structure according to formula I, II, III or IV as defined in claim 1 and casting, spin coating, doctor's blading or ink-jet printing the solution onto a substrate, either in the form of a continuous film or having a predesigned pattern, wherein the material is applied as a chemically homogenous mixture throughout the film or patterned layer.

**21.** Method for the preparation of a material according to claim 13, variant (a), comprising preparing a film as defined in claim 20 and irradiating said film or a part of it with a homogeneous light field.

**22.** Method for the preparation of a material according to claims 13, variant (b), and 14, comprising preparing a film as defined in claim 20 and irradiating said film or part of it with an inhomogeneous light field, provided by a mask or by an interference pattern of at least two intersecting coherent beams.

**23.** Method according to claims 21 or 22, wherein either the wavelength, the irradiation time, the number of the irradiating beams and/or the polarization, the intensity, the incidence angle of at least one irradiating beam is varied to control the direction, the value and/or the modulation type of the induced optical anisotropy.

**24.** Method according to claims 22 or 23, further comprising varying the mask spacing or the period of the interference pattern in order to control the spatial modulation of optical anisotropy.

**25.** Method for the preparation of a material according to claims 15 and 16, comprising preparing a film as defined in claim 20 and inhomogeneously irradiating said film, preferably through a mask, with a focused beam, with near field, or with an interference pattern of at least two intersecting coherent beams.

**26.** Method for the preparation of a material according to claims 15 and 16, comprising preparing a film as defined in claim 25 and further changing of once inscribed structures (correcting or overwriting) by successive irradiation using the method according to claim 25.

**27.** Method according to claim 25 or 26, wherein structures with complicated (non-rectangular and non-sinusoidal) profile are prepared by multi-step (successive) irradiation, preferably with the interference patterns corresponding to the Fourier components of the desired profile.

**28.** Method according to claim 25 or 26, wherein complicated multidimensional structures are prepared by multi-step (successive) irradiation, preferably differing by the position of the material, irradiation conditions and/or the interference pattern.

**29.** Method for the preparation of a material according to claim 17, variant (a), or 18, comprising alternative preparation of a film as defined in claims 21 to 28 and erasure of the induced changes by either homogeneous irradiation of said film or part of it with a light or/and by heating it.

**30.** Method according to claim 29, wherein either the wavelength, the irradiation time, the polarization, the intensity, the incidence angle of erasing beam and/or the temperature, rate, time of heating is varied to control the velocity and degree of the erasure and the final state of the material.

**31.** Use of a film as claimed in any of claims 1 to 19 as a photosensitive medium, optical element, functional surface and/or template.

**32.** Use of a film as claimed in claims 17 to 19, wherein the light-induced property is reversible, as an element for optical or optical/thermal switching, the material preferably being prepared by a method according to claim 29 or 30.

**33.** Use of a film as claimed in claims 17, variant (a) and 19, wherein the light-induced property is reversible, as a medium for real-time holography or optical information processing.

**34.** Use according to claim 31, wherein the optical element is selected preferably from diffractive element, polarization element, focusing element or any combination of said elements.

**35.** Use according to claim 31, wherein the photosensitive medium is a medium for irreversible or reversible optical data storage.

**36.** Use according to claim 35, wherein written information can be eliminated by irradiation or heating, whereafter another writing cycle is possible.

**37.** Use according to claim 31, wherein the template surface is a surface for replication to another material or the command surface for aligning of liquid crystals, self-organization of particles.

**38.** Use according to claim 31, wherein the functional surface is the surface determining the chemical, mechanical, optical properties of the material, preferably selected from wetting/dewetting, hardness, reflectance, scattering.

**39.** Method for the preparation of a replica of a surface relief structure, comprising the following steps:

a. preparing a film according to any of claims 15 and 16 ("first material") using a method as claimed in any of claims 25 to 28, to obtain a surface relief structure thereon;
b. covering said relief structure or a part thereof with a second material, selected from organic and inorganic-organic polymers and/or metals;
c. curing or hardening said second material, if required;
d. separating said second material from the surface relief grating of the first material, to obtain a (negative) replica and optionally
e. repeating steps (b) to (d), if more than one replica from the said surface relief structure shall be obtained.

**40.** Method for the preparation of a reproduction replica of an original surface relief structure, comprising the following steps:

a. preparing a material according to any of claims 15 and 16 ("first material") using a method as claimed in any of claims 25 to 28, to obtain a surface relief structure thereon;
b. covering said relief structure or a part thereof with a second material, selected from organic and inorganic-organic polymers and/or metals;
c. curing or hardening said second material, if required;
d. separating said second material from the surface relief grating of the first material or washing out said first material with a suitable solvent to obtain a (negative) replica,
e. covering the negative relief structure of the replica with a third material, selected from organic and inorganic-organic polymers and metal,
f. curing or hardening said third metal, if required,
g. separating said third material from the surface relief grating of the second material, to obtain a (positive) replication replica of the original surface relief structure, and
h. repeating steps (e) to (g), if more than one reproduction replica from the said surface relief structure shall be obtained.

## Patentansprüche

**1.** Homogener, photoaktiver Film aus einem Material, das aus einem Polyelektrolyten besteht, der Reste trägt, welche eine Photoreaktion eingehen können, ausgewählt unter Photoisomerisierungen, Photocycloadditionen und photoinduzierten Umlagerungen, oder das einen solchen Polyelektrolyten enthält, wobei der Polyelektrolyt im wesentlichen aus mindestens einer Struktur gemäß Formel I oder Formel II

$$[Pol(R^*\text{-}P\text{-}R')]_o^{on+}\ n/x\ A^{x-}\ (I),$$

oder

$$n/x\ A^{x+}\ [Pol(R^*\text{-}P\text{-}R')\ ]_o^{on-}\ (II),$$

und/oder gemäß Formel III oder IV:

$$[Pol(R^{1*}\text{-}Q\text{-}R^{1'})]_o^{on+}\ n/x\ A^{x-}\ \ (III),$$

oder

$$n/x\ A^{x+}\ \ [Pol(R^{1*}\text{-}Q\text{-}R^{1'})]_o^{on-}\qquad (IV)$$

besteht oder diese als Hauptkomponente enthält, worin Pol eine sich wiederholende Einheit einer linearen oder verzweigen Polymerkette bedeutet, o die Anzahl der sich wiederholenden Einheiten der Polymerkette angibt und

($R^*$-P-R') und ($R^{1*}$-Q-$R^{1'}$) n-fache, positiv oder negativ geladene Seitenketten der sich wiederholenden Einheit Pol darstellen, worin

P eine einer photoinduzierten E/Z-Isomerisierung zugängliche Gruppe ist,

$R^*$ ausgewählt ist unter gegebenenfalls substituierten und/oder funktionalisierten arylhaltigen Gruppen, die an die sich wiederholende Einheit Pol und an die Gruppe P gebunden sind,

R' ausgewählt ist unter gegebenenfalls substituierten und/oder funktionalisierten arylhalten Gruppen, worin mindestens eine der Gruppen $R^*$ und R' positiv oder negativ geladen ist,

Q eine Gruppe ist, die Partner in einer Photocycloadditionsreaktion oder Partner in einer photoinduzierten Umlagerungsreaktion oder in der sogenannten Photo-Fries-Reaktion sein kann,

$R^{1*}$ ausgewählt ist unter gegebenenfalls substituierten oder funktionalisierten Gruppen, die Elektronenakzeptor-Eigenschaften besitzen, und an die sich wiederholende Einheit Pol und an die Gruppe Q gebunden ist,

$R^{1'}$ ausgewählt ist unter gegebenenfalls substituierten oder funktionalisierten Gruppen, die Elektronenakzeptor-Eigenschaften besitzen oder mindestens eine Aryleinheit oder (eine) solche Gruppe(n) enthalten, die zusammen mit Q einen Arylring oder einen Heteroarylring bilden,

worin mindestens eine der Gruppen $R^{1*}$ und $R^{1'}$ positiv oder negativ geladen ist oder worin die Ringstruktur, die $R^{1'}$ und Q enthält, und/oder ein Substituent daran mindestens eine positive oder negative Ladung trägt,

A ein Kation oder Anion mit entgegengesetzter Ladung ist,

n 1, 2, 3 oder 4 ist,

x 1 oder 2 ist, und

o mindestens 2 ist,

mit der Maßgabe, dass in einem Polyelektrolyten die Gruppen Pol und/oder [R-P-R'] und/oder [$R^1$-Q-$R^{1'}$] alle dasselbe Vorzeichen besitzen,

worin der homogene Film eine Dicke von mindestens 10nm aufweist.

**2.** Film gemäß Anspruch 1, worin die Strukturen (I) bis (IV) die folgenden Formeln besitzen

$$[Pol(R^*\text{-}P\text{-}R'^{n+})]_o\ n/x\ A^{x-}\quad (I'),$$

oder

$$n/x\ A^{x+}\ [Pol(R^*\text{-}P\text{-}R'^{n-})]_o\quad (II'),$$

oder

$$[Pol(R^{1*}\text{-}Q\text{-}R^{1'n+})]_o\ n/x\ A^{x-}\ \ (III'),$$

oder

$$n/x\ A^{x-}\ \ [Pol(R^{1*}\text{-}Q\text{-}R^{1'n-})]_o\ \ (IV').$$

**3.** Film nach Anspruch 1 oder 2,worin die Gruppe P und die Gruppe Q in den Formeln (I) bis (IV) ausgewählt sind unter -N=N-, -$CR^2$=$CR^{2'}$-, wobei $R^2$, $R^{2'}$ unabhängig voneinander ausgewählt sind unter H, CN oder $C_1$-$C_4$-Alkyl, und einer Gruppe, die die mehr als eine -N=N- und/oder -$CR^2$=$CR^{2'}$-Einheit in einem elektronenkonjugierten System aufweist,

**4.** Film nach einem der Ansprüche 1 bis 3, worin in den Formeln (I) oder (II) die Aryleinheiten von R, R direkt an die Gruppe P gebunden sind, und/oder worin in den Formeln (III) oder (IV) $R^1$ und $R^{1'}$ ausgewählt sind unter direkt an Q gebundenen Arylgruppen und -C(O)O- und -(CO)$NR^3$-Gruppen, in denen $R^3$ H

oder eine gegebenenfalls substituierte Alkyl- oder Arylgruppe ist.

**5.** Film nach einem der Ansprüche 1 bis 3, worin die Seitenketten des Polyelektrolyten ausgewählt sind unter Monoazo-Verbindungen, Bisazo-Verbindungen, Trisazo-Verbindungen und vorzugsweise unter Azobenzol-Gruppen, Bisazobenzol-Gruppen, Trisazobenzol-Gruppen, und weiterhin unter Stilben-Gruppen, Cinnamat-Gruppen, Iminen, Anthracen-Gruppen, Cumarin-Gruppen, Chalcon-Gruppen, p-Phenylen-diacrylaten oder -diacrylamiden, Thymin-Derivaten, Cytosin-Derivaten, Merocyaninen/Spiropyranen und Gruppen, die Maleinsäureanhydrid enthalten.

**6.** Film nach einem der Ansprüche 1 bis 5, worin R* und $R^{1*}$ über eine Kohlenstoff-Kohlenstoff-Bindung oder über eine Ether-, Ester-, Amin-, Amid-, Harnstoff-, Guanidino- oder Sulfonamid-Gruppe an die Monomereinheiten von Pol gebunden sind.

**7.** Film nach einem der Ansprüche 1 bis 6, enthaltend mindestens einen Zusatz, der die Eigenschaften des Materials modifiziert, vorzugsweise ausgewählt unter organischen Polymeren, Verbindungen mit filmbildenden Eigenschaften, Plastifizierern, Flüssigkristallen und anderen photoempfindlichen Verbindungen als denjenigen, die in Anspruch 1 definiert sind.

**8.** Film nach Anspruch 7, worin das Film-Material zusätzlich ein monomeres, photoempfindliches Molekül enthält, das sich einer Polymerisation unterziehen oder eine Vernetzung ergeben kann, die entweder durch Bestrahlung mit Licht oder durch thermische Behandlung induziert werden.

**9.** Film nach einem der voranstehenden Ansprüche, worin die Filmbildung aus einem umweltfreundlichen Lösungsmittel wie einer Wasser-Alkohol-Lösung heraus erfolgte.

**10.** Film nach einem der voranstehenden Ansprüche, worin Filmstapel aus dem genannten Material und einem zusätzlichen Polymermaterial, das in einem organischen Lösungsmittel, aber nicht in einer Wasser-Alkohol-Lösung löslich ist, hergestellt wurden, derart, dass die orientierten und die Oberflächenrelief-Strukturen durch das zusätzliche Polymermaterial laminierbar sind, um die aktive Schicht zu schützen, und zum Herstellen von multifunktionellen Stapeln auf Basis von Materialien mit unterschiedlichen Funktionen.

**11.** Film nach einem der voranstehenden Ansprüche, entweder als Schicht auf einem Substrat angeordnet oder in der Form eines freitragenden Films, wobei der Film gegebenenfalls ein Muster aufweist.

**12.** Film nach einem der voranstehenden Ansprüche, worin mindestens eine optische Eigenschaft des Films, vorzugsweise ausgewählt ist unter Lichtbrechung, Absorption, Doppelbrechung, Dichroismus oder Gyrotropie, durch Bestrahlung mit Licht verändert wurde.

**13.** Film nach Anspruch 12, worin die sich ändernden optischen Eigenschaften entweder

(a) durch das Material hindurch homogen sind oder
(b) durch das Material hindurch oder durch beschränkte Bereiche davon variieren.

**14.** Film nach Anspruch 13, Variante (b), in welchem optische Eigenschaften in einer, zwei oder drei Raumrichtungen moduliert sind, einschließlich der Richtung, die rechtwinklig zur Filmebene liegt, einer beliebigen Richtung in der Filmebene oder entlang der Achse, die gegenüber der Filmebene verkippt ist.

**15.** Film nach einem der voranstehenden Ansprüche, wobei der Film auf einem Substrat angeordnet oder ein freitragender Film ist, der mindestens eine freie Oberfläche aufweist, die eine lichtinduzierte Reliefstruktur zeigt.

**16.** Film nach Anspruch 15, worin die Reliefstruktur ein regelmäßiges Muster mit einer Höhe aufweist, die in einer oder zwei Dimensionen moduliert ist.

**17.** Film nach den Ansprüchen 12 bis 16, worin die induzierten Veränderungen der optischen Eigenschaften und/oder der induzierten Reliefstruktur entweder

a. reversibel oder
b. irreversibel

sind.

**18.** Film nach Anspruch 17, Variante (a), worin die Veränderungen der optischen Eigenschaften und/oder der Reliefstruktur stabil sind, wenn der Film am Tageslicht unterhalb der Glasübergangstemperatur oder der Zersetzungstemperatur gehalten wird.

**19.** Film nach den Ansprüchen 17, Variante (a), und 18, worin die Veränderungen der optischen Eigenschaften und/oder der Reliefstruktur cyclisch mit Licht induziert und optisch oder thermisch gelöscht werden.

**20.** Verfahren zum Herstellen eines Films nach einem der Ansprüche 1 bis 11, umfassend das Lösen eines Polyelektrolyten, der im Wesentlichen aus mindestens einer Struktur gemäß Formel I, II, III oder IV wie in Anspruch 1 definiert besteht oder diese als

Hauptkomponente enthält, und Formgießen, Spin-Coaten, Aufrakeln oder Tintenstrahldrucken der Lösung auf ein Substrat, entweder in Form eines durchgehenden Films oder mit einem vorgegebenen Muster, wobei das Material als chemisch homogene Mischung über den gesamten Film oder die gemusterte Schicht hinweg aufgebracht wird.

**21.** Verfahren zum Herstellen eines Materials nach Anspruch 13, Variante (a), umfassend das Herstellen eines Films wie in Anspruch 20 definiert und Bestrahlen dieses Films oder eines Teils davon mit einem homogenen Lichtfeld.

**22.** Verfahren zum Herstellen eines Materials nach den Ansprüchen 13, Variante (b) und 14, umfassend das Herstellen eines Films wie in Anspruch 20 definiert und Bestrahlen dieses Films oder eines Teils davon mit einem inhomogenen Lichtfeld, das durch eine Maske oder ein Interferenzmuster aus mindestens zwei einander schneidenden, kohärenten Strahlungsbündeln bereitgestellt wird.

**23.** Verfahren nach den Ansprüchen 21 oder 22, worin entweder die Wellenlänge, die Bestrahlungszeit, die Anzahl der Strahlenbündel und/oder die Polarisation, die Intensität, der Einstrahlwinkel mindestens eines der Strahlenbündel variiert wird, um die Richtung, den Wert und/oder die Modulationsart der induzierten optischen Anisotropie zu steuern.

**24.** Verfahren nach den Ansprüchen 22 oder 23, weiterhin umfassend das Variieren des Maskenabstands oder der Periode des Interferenzmusters, um die räumliche Modulation der optischen Aniostropie zu steuern.

**25.** Verfahren zum Herstellen eines Materials gemäß den Ansprüchen 15 und 16, umfassend das Herstellen eines Films wie in Anspruch 20 definiert und das inhomogene Bestrahlen dieses Films, vorzugsweise durch eine Maske, mit einem fokussierten Strahlenbündel, mit einem Nahfeld oder mit einem Interferenzmuster aus mindestens zwei einander schneidenden, kohärenten Strahlenbündeln.

**26.** Verfahren zum Herstellen eines Materials gemäß den Ansprüchen 15 und 16, umfassend das Herstellen eines Films wie in Anspruch 25 definiert und weiterhin das Verändern von zuvor eingeschriebenen Strukturen (Korrigieren oder Überschreiben) durch nachfolgendes Bestrahlen unter Verwenden des Verfahrens gemäß Anspruch 25.

**27.** Verfahren gemäß Anspruch 25 oder 26, worin Strukturen mit kompliziertem (nichtrechtwinkligem und nicht-sinusförmigem) Profil durch Bestrahlen mittels (einer Abfolge von) Mehrfachschritten hergestellt werden, wobei vorzugsweise die Interferenzmuster den Fourier-Komponenten des gewünschten Profils entsprechen.

**28.** Verfahren nach Anspruch 25 oder 26, worin komplizierte multidimensionale Strukturen durch Bestrahlen mittels (einer Abfolge von) Mehrfachschritten hergestellt werden, die sich vorzugsweise hinsichtlich der Positionierung des Materials, den Bestrahlungsbedingungen und/oder dem Interferenzmuster unterscheiden.

**29.** Verfahren zum Herstellen eines Materials nach Anspruch 17, Variante (a), oder 18, umfassend das abwechselnde Herstellen eines Films wie in den Ansprüchen 21 bis 28 definiert und das Löschen der induzierten Veränderungen entweder durch homogene Bestrahlung des genannten Films oder eines Teils davon mit Licht oder durch dessen Erwärmen.

**30.** Verfahren nach Anspruch 29, worin entweder die Wellenlänge, die Bestrahlungszeit, die Polarisation, die Intensität oder der Einfallswinkel des löschenden Lichtbündels und/oder die Temperatur, die Geschwindigkeit oder der Erwärmungs-Zeitraum variiert werden, um die Geschwindigkeit und den Grad der Löschung und den Endzustand des Materials zu steuern.

**31.** Verwendung eines Films wie in einem der Ansprüche 1 bis 19 beansprucht als photoempfindliches Medium, optisches Element, funktionelle Oberfläche und/oder Abform-Vorlage.

**32.** Verwendung eines Films wie in einem der Ansprüche 17 bis 19 beansprucht, worin die lichtinduzierte Eigenschaft reversibel ist, als Element für optisches oder optisches/thermisches Schalten, wobei das Material vorzugsweise durch ein Verfahren gemäß Anspruch 29 oder 30 hergestellt wird.

**33.** Verwendung eines Films wie in den Ansprüchen 17, Variante (a), und 19 beansprucht, worin die lichtinduzierte Eigenschaft reversibel ist, als Medium für Echtzeit-Holographie oder optische Informationsverarbeitung.

**34.** Verwendung nach Anspruch 31, worin das optische Element vorzugsweise ausgewählt ist unter einem Beugungselement, einem Polarisationselement, einem fokussierenden Element oder einer beliebigen Kombination dieser Elemente.

**35.** Verwendung nach Anspruch 31, worin das photoempfindliche Medium ein Medium für die irreversible oder reversible optische Datenspeicherung ist.

**36.** Verwendung nach Anspruch 35, worin eingeschriebene Information durch Bestrahlen oder Erwärmen gelöscht werden kann, worauf ein weiterer Schreibzyklus möglich ist.

**37.** Verwendung nach Anspruch 31, worin die Oberfläche der Abform-Vorlage eine Oberfläche für die Übertragung auf ein anderes Material oder die Steuerungsoberfläche für die Ausrichtung von Flüssigkristallen, die Selbstorganisation von Teilchen ist.

**38.** Verwendung nach Anspruch 31, worin die funktionelle Oberfläche die Oberfläche ist, die die chemischen, mechanischen, optischen Eigenschaften des Materials bestimmt, vorzugsweise ausgewählt unter Benetzbarkeit/Entfeuchtung, Härte, Reflexion und Lichtstreuung.

**39.** Verfahren zum Herstellen einer abgeformten Kopie einer Oberflächen-Reliefstruktur, umfassend die folgenden Schritte:

a. Herstellen eines Films gemäß einem der Ansprüche 15 und 16 (eines "ersten Materials") unter Verwendung eines Verfahrens wie in einem der Ansprüche 25 bis 28 beansprucht, wobei darauf eine Oberflächen-Reliefstruktur ausgebildet wird;
b. Bedecken der genannten Reliefstruktur oder eines Teils davon mit einem zweiten Material, ausgewählt unter organischen und anorganisch-organischen Polymeren und/oder Metallen:
c. Vernetzen oder Härten des zweiten Materials, sofern erforderlich;
d. Trennen des zweiten Materials von dem Oberflächen-Reliefgitter des ersten Materials, wobei eine (negative) abgeformte Kopie erhalten wird, und gegebenenfalls
e. das Wiederholen der Schritte (b) bis (d), wenn mehr als eine abgeformte Kopie von der genannten Oberflächen-Reliefstruktur gewonnen werden soll.

**40.** Verfahren zum Herstellen einer abgeformten Reproduktions-Kopie einer originalen Oberflächen-Reliefstruktur, umfassend die folgenden Schritte:

a. Herstellen eines Films gemäß einem der Ansprüche 15 und 16 (eines "ersten Materials") unter Verwendung eines Verfahrens wie in einem der Ansprüche 25 bis 28 beansprucht, wobei darauf eine Oberflächen-Reliefstruktur ausgebildet wird;
b. Bedecken der genannten Reliefstruktur oder eines Teils davon mit einem zweiten Material, ausgewählt unter organischen und anorganisch-organischen Polymeren und/oder Metallen;
c. Vernetzen oder Härten des zweiten Materials, sofern erforderlich;
d. Trennen des zweiten Materials von dem Oberflächen-Reliefgitter des ersten Materials oder Wegwaschen des ersten Materials mit einem geeigneten Lösungsmittel, wobei eine (negative) abgeformte Kopie erhalten wird,
e. Bedecken der negativen Reliefstruktur der abgeformten Kopie mit einem dritten Material, ausgewählt unter organischen und anorganisch-organischen Polymeren und/oder Metall,
f. Vernetzen oder Härten des dritten Materials, sofern erforderlich;
g. Trennen des dritten Materials von dem Oberflächen-Reliefgitter des zweiten Materials, wobei eine (positive) abgeformte Replikations-Kopie der ursprünglichen Oberflächen-Reliefstruktur erhalten wird,
h. das Wiederholen der Schritte (e) bis (g), wenn mehr als eine abgeformte Reproduktions-Kopie von der genannten Oberflächen-Reliefstruktur gewonnen werden soll.

## Revendications

**1.** Film photoactif homogène fabriqué dans matériau constitué d'un (ou comprenant un) polyélectrolyte comportant des résidus pouvant subir une photoréaction choisie parmi les photo-isomérisations, les photocycloadditions et les réarrangements photo-induits, le polyélectrolyte étant essentiellement constitué d'au moins (ou comprenant principalement au moins) une structure selon la formule I ou la formule II :

$$[Pol(R^{*}\text{-}P\text{-}R')]_{o}^{on+}\ n/x\ A^{x-}\ (I),$$

ou

$$n/x\ A^{*+}\ [Pol(R^{*}\text{-}P\text{-}R')]_{o}^{on-}\ (II),$$

et/ou de formule III ou IV :

$$[Pol(R^{1*}\text{-}Q\text{-}R^{1'})]_{o}^{on+}\ n/x\ A^{x-}\ (III),$$

ou

$$n/x\ A^{*+}\ [Pol\ (R^{1*}\text{-}Q\text{-}R^{1'})]_{o}^{on-}\ (IV),$$

dans lesquelles Pol représente un motif de répétition d'une chaîne polymère linéaire ou ramifiée, o indique le numéro du motif de répétition de la chaîne polymère, et

($R^*$-P-R') et ($R^{1*}$-Q-$R^{1'}$) sont des chaînes latérales chargées positivement ou négativement n fois du motif de répétition Pol,

P représentant un groupe capable d'isomérisation E/Z photo-induite,

R* est choisi parmi des groupes contenant un aryle éventuellement substitués et/ou fonctionnalisés liés au motif de répétition Pol et au groupe P,

R' est choisi parmi des groupes contenant un aryle éventuellement substitués et/ou fonctionnalisés,

au moins l'un des deux R* et R' étant chargé positivement ou négativement, Q est un groupe capable de participer à une photocycloaddition ou bien à un réarrangement photo-induit ou à ladite photoréaction de Fries,

$R^{1*}$ est choisi parmi des groupes éventuellement substitués ou fonctionnalisés ayant des propriétés électrophiles et est lié au motif de répétition Pol et au groupe Q,

$R^{1'}$ est choisi parmi des groupes éventuellement substitués ou fonctionnalisés ayant des propriétés électrophiles ou comprenant au moins un fragment aryle ou ce type de groupe(s) formant conjointement avec Q un noyau aryle ou un noyau hétéroaryle,

au moins l'un des deux $R^{1*}$ et $R^{1'}$ est chargé positivement ou négativement ou la structure cyclique comprenant $R^{1'}$ et Q et/ou un substituant placé dessus portera au moins une charge positive ou négative,

A est un cation ou un anion de charge opposée,

n vaut 1, 2, 3 ou 4,

X vaut 1 ou 2, et

o vaut au moins 2,

à condition que dans un polyélectrolyte, les groupes Pol et/ou [R-P-R'] et/ou [$R^1$-Q-$R^{1'}$] aient tous le même signe,

le film homogène ayant une épaisseur d'au moins 10 nm.

**2.** Film selon la revendication 1, dans lequel les structures (I) à (IV) présentent les formules

$$[Pol(R^*\text{-}P\text{-}R'^{n+})]_o\ n/x\ A^{x-}\ (I'),$$

ou

$$n/x\ A^{*+}\ [Pol(R^*\text{-}P\text{-}R'^{n-})]_o\ (II'),$$

ou

$$[Pol(R^{1*}\text{-}Q\text{-}R^{1'n+})]_o,\ n/x\ A^{x-}\ (III'),$$

ou

$$n/x\ A^{*-}\ [Pol(R^{1*}\text{-}Q\text{-}R^{1'n-})]_o\ (IV'),$$

**3.** Film selon la revendication 1 ou 2, dans lequel le groupe P et le groupe Q dans les formules (I) à (IV) sont choisis parmi -N=N, -$CR^2$=$CR^{2'}$-, $R^2$, $R^{2'}$ étant choisis indépendamment parmi H, CN ou un groupe alkyle en $C_1$-$C_4$ et un groupe contenant plus d'un fragment -N=N- et/ou -$CR^2$=$CR^{2'}$- dans un système conjugué d'électrons.

**4.** Film selon l'une quelconque des revendications 1 à 3, dans lequel, dans les formules (I) ou (II), les fragments aryle de R, R sont directement liés au groupe P, et/ou dans lequel, dans les formules (III) ou (IV), $R^1$ et $R^{1'}$ sont choisis parmi des fragments aryle directement liés à Q et les groupes -C(O)O- et -(CO)$NR^3$ dans lequel $R^3$ représente H ou un groupe alkyle ou aryle éventuellement substitué.

**5.** Film selon l'une quelconque des revendications 1 à 3, dans lequel les chaînes latérales du polyélectrolyte sont choisies parmi des groupes monoazoïques, des groupes bisazoïques, des groupes trisazoïques et de préférence, parmi des groupes azobenzène, des groupes bisazobenzène, des groupes trisazobenzène et en outre parmi des groupes stilbène, des groupes cinnamate, des imines, des groupes anthracène, des groupes coumarine, des groupes chalcone, des diacrylates ou diacrylamides de p-phénylène, des dérivés de la thymine, des dérivés de la cytosine, des mérocyanines/spiropyranes et des groupes contenant de l'anhydride maléique.

**6.** Film selon l'une quelconque des revendications 1 à 5, dans lequel $R^*$ et $R^{1*}$ sont liés aux unités monomères Pol *via* une liaison carbone-carbone ou avec un éther, un ester, une amine, un amide, un groupe urée, guanidino ou sulfonamido.

**7.** Film selon l'une quelconque des revendications 1 à 6, comprenant au moins un additif modifiant les propriétés du matériau, de préférence choisi parmi les polymères organiques, les composés ayant des propriétés filmogènes, les plastifiants, les cristaux liquides et les composés photosensibles différents de ceux définis dans la revendication 1.

**8.** Film selon la revendication 7, le matériau du film comprenant de plus une molécule monomère photosensible capable de supporter une polymérisation

ou de permettre une réticulation, induite soit par irradiation avec un faisceau lumineux, soit par traitement thermique.

**9.** Film selon l'une quelconque des revendications précédentes, dans lequel la formation du film a été réalisée à partir d'un solvant écologique, par exemple une solution d'eau et d'alcool.

**10.** Film selon l'une quelconque des revendications précédentes, dans lequel on a préparé des piles de films à partir dudit matériau et d'un matériau polymère supplémentaire soluble dans un solvant organique mais insoluble dans la solution d'eau et d'alcool, pour permettre la stratification des structures orientationnelles et à relief de surface par le matériau polymère supplémentaire afin d'empêcher la couche active, et pour préparer des piles multifonctionnelles à base de matériaux ayant différentes fonctions.

**11.** Film selon l'une quelconque des revendications précédentes, soit placé sous forme de couche sur un substrat, soit placé sous forme de film autonome, le film comportant éventuellement des motifs.

**12.** Film selon l'une quelconque des revendications précédentes, dans lequel au moins une propriété optique du film, de préférence choisie parmi la réfraction, l'absorption, la biréfringence, le dichroïsme ou la gyrotropie, a été modifiée lors de l'irradiation avec un faisceau lumineux.

**13.** Film selon la revendication 12, dans lequel les propriétés optiques changeantes sont soit :

a. homogènes dans tout le matériau ou
b. variables dans le matériau ou sur certaines zones limitées de celui-ci.

**14.** Film selon la revendication 13, variante (b), dans lequel les propriétés optiques sont modulées dans une, deux ou trois dimensions, y compris avec une modulation dans la direction perpendiculaire au plan du film, dans n'importe quelle direction dans le plan du film ou bien le long de l'axe incliné par rapport au plan du film.

**15.** Film selon l'une quelconque des revendications précédentes, dans lequel le film est placé sur un substrat ou bien est un film autonome, et au moins une de ses surfaces libres présente une structure à relief photo-induite.

**16.** Film selon la revendication 15, dans lequel la structure à relief est un motif régulier dont la hauteur est modulée dans une ou deux dimensions.

**17.** Film selon les revendications 12 à 16, dans lequel les modifications induites des propriétés optiques et/ou de la structure à relief induite sont soit :

a. réversibles, soit
b. irréversibles.

**18.** Film selon la revendication 17, variante (a), dans lequel les modifications des propriétés optiques et/ou de la structure à relief sont stables lorsqu'il est conservé à la lumière du jour, en dessous de la température de transition vitreuse ou en dessous de la température de décomposition.

**19.** Film selon les revendications 17, variante (a) et 18, dans lequel les modifications des propriétés optiques et/ou de la structure à relief sont cycliquement induites avec un faisceau lumineux et effacées optiquement ou thermiquement.

**20.** Procédé de préparation d'un film selon l'une quelconque des revendications 1 à 11, comprenant la dissolution d'un polyélectrolyte consistant essentiellement en ou comprenant principalement au moins une structure selon la formule I, II, III ou IV comme défini dans la revendication 1 et la coulée, l'enduction centrifuge *(spin coating),* l'enduction à la lame *(doctor's blading*) ou la pulvérisation à la manière d'une impression par jet d'encre de la solution sur un substrat, soit sous la forme d'un film continu, soit sous forme de film ayant des motifs préalablement conçus, où l'on applique le matériau sous forme de mélange chimiquement homogène sur tout le film ou sous forme de couche à motifs.

**21.** Procédé de préparation d'un matériau selon la revendication 13, variante (a), comprenant la préparation d'un film tel que défini dans la revendication 20 et l'irradiation dudit film ou d'une partie de celuici avec un champ lumineux homogène.

**22.** Procédé de préparation d'un matériau selon les revendications 13, variante (b) et 14, comprenant la préparation d'un film selon la revendication 20 et l'irradiation dudit film ou d'une partie de celui-ci avec un champ lumineux hétérogène, à l'aide d'un masque ou d'un motif d'interférence constitué d'au moins deux faisceaux cohérents qui se coupent.

**23.** Procédé selon la revendication 21 ou 22, dans lequel la longueur d'onde, le temps d'irradiation, le nombre de faisceaux irradiants et/ou la polarisation, l'intensité, l'angle d'incidence d'au moins un faisceau irradiant varie(nt) pour contrôler la direction, la valeur et/ou le type de modulation de l'anisotropie optique induite.

**24.** Procédé selon la revendication 22 ou 23, comprenant en outre la modification de l'écartement du masque ou de la période du motif d'interférence afin de contrôler la modulation spatiale de l'anisotropie optique.

**25.** Procédé pour la préparation d'un matériau selon les revendications 15 et 16, comprenant la préparation d'un film comme défini dans la revendication 20 et l'irradiation hétérogène dudit film, de préférence à travers un masque, avec un faisceau focalisé, avec un champ proche, ou avec un motif d'interférence constitué d'au moins deux faisceaux cohérents qui se coupent.

**26.** Procédé pour la préparation d'un matériau selon les revendications 15 et 16, comprenant la préparation d'un film comme défini dans la revendication 25 et un autre changement des structures inscrites antérieurement (correction ou réécriture) par irradiation successive en utilisant le procédé selon la revendication 25.

**27.** Procédé selon la revendication 25 ou 26, dans lequel les structures ayant un profil compliqué (non rectangulaire et non sinusoïdal) sont préparées par irradiation en plusieurs étapes (successives), de préférence avec les motifs d'interférence correspondant aux composants de Fourier du profil souhaité.

**28.** Procédé selon la revendication 25 ou 26, dans lequel les structures multidimensionnelles compliquées sont préparées par irradiation en plusieurs étapes (successives), différant de préférence par la position du matériau, les conditions d'irradiation et/ou le motif d'interférence.

**29.** Procédé pour la préparation d'un matériau selon les revendications 17, variante (a), ou 18, comprenant la préparation alternative d'un film comme défini dans les revendications 21 à 28 et l'effacement des changements induits, par irradiation homogène dudit film ou d'une partie de celui-ci avec un faisceau lumineux et/ou par chauffage dudit film.

**30.** Procédé selon la revendication 29, dans lequel la longueur d'onde, le temps d'irradiation, la polarisation, l'intensité, l'angle d'incidence du faisceau d'effacement et/ou la température, la vitesse, le temps de chauffage varie(nt) pour contrôler la vitesse et le degré d'effacement et l'état final du matériau.

**31.** Utilisation d'un film selon l'une quelconque des revendications 1 à 19, en tant que support photosensible, élément optique, surface fonctionnelle et/ou matrice.

**32.** Utilisation d'un film selon les revendications 17 à 19, dans laquelle la propriété photo-induite est réversible, en tant qu'élément pour commutation optique ou thermo-optique, le matériau étant de préférence préparé par un procédé selon la revendication 29 ou 30.

**33.** Utilisation d'un film selon les revendications 17, variante (a) et 19, dans laquelle la propriété photo-induite est réversible, en tant que support pour holographie en temps réel ou pour traitement optique de l'information.

**34.** Utilisation selon la revendication 31, dans laquelle l'élément optique est choisi de préférence parmi un élément de diffraction, un élément de polarisation, un élément de focalisation ou toute combinaison desdits éléments.

**35.** Utilisation selon la revendication 31, dans laquelle le support photosensible est un support pour stockage réversible ou irréversible des données optiques.

**36.** Utilisation selon la revendication 35, dans laquelle les informations écrites peuvent être supprimées par irradiation ou chauffage, après quoi un autre cycle d'écriture est possible.

**37.** Utilisation selon la revendication 31, dans laquelle la surface de matrice est une surface permettant la reproduction sur un autre matériau ou la surface de commande permettant d'aligner des cristaux liquides ou permettant l'auto-organisation des particules.

**38.** Utilisation selon la revendication 31, dans laquelle la surface fonctionnelle est la surface déterminant les propriétés chimiques, mécaniques ou optiques du matériau, choisies de préférence parmi le mouillage/démouillage, la dureté, le facteur de réflexion ou la diffusion.

**39.** Procédé pour la préparation d'une réplique d'une structure à relief de surface, comprenant les étapes suivantes consistant à :

a. préparer un film selon l'une quelconque des revendications 15 et 16
(« premier matériau ») en utilisant un procédé selon l'une quelconque des revendications 25 à 28 afin d'obtenir sur ce film une structure à relief de surface ;
b. couvrir ladite structure à relief ou une partie de celle-ci avec un second matériau choisi parmi des polymères organiques et inorganiques-organiques et/ou des métaux ;
c. cuire ou faire durcir le second matériau le cas échéant ;
d. séparer ledit second matériau et le quadrillage à relief de surface du premier matériau afin d'obtenir une réplique (négative) et éventuellement,

e. répéter les étapes (b) à (d) si l'on doit obtenir plus d'une réplique à partir de ladite structure à relief de surface.

**40.** Procédé pour la préparation d'une réplique d'une structure à relief de surface originale comprenant les étapes suivantes consistant à :

a. préparer un film selon l'une quelconque des revendications 15 et 16
(« premier matériau ») en utilisant un procédé selon l'une quelconque des revendications 25 à 28 afin d'obtenir sur ce film une structure à relief de surface ;
b. couvrir ladite structure à relief ou une partie de celle-ci avec un second matériau choisi parmi des polymères organiques et inorganiques-organiques et/ou des métaux ;
c. cuire ou faire durcir ledit deuxième matériau le cas échéant ;
d. séparer ledit deuxième matériau et le quadrillage à relief de surface du premier matériau ou bien l'élimination dudit premier matériau à l'aide d'un solvant adapté afin d'obtenir une réplique (négative),
e. couvrir la structure à relief négative de la réplique avec un troisième matériau choisi parmi des polymères organiques et inorganiques-organiques et des métaux,
f. cuire ou faire durcir ledit troisième matériau le cas échéant,
g. séparer ledit troisième matériau et le quadrillage à relief de surface du deuxième matériau pour obtenir une réplique (positive) de la structure à relief de surface originale, et
h. répéter les étapes (e) à (g) si l'on doit obtenir plus d'une réplique à partir de ladite structure à relief de surface.

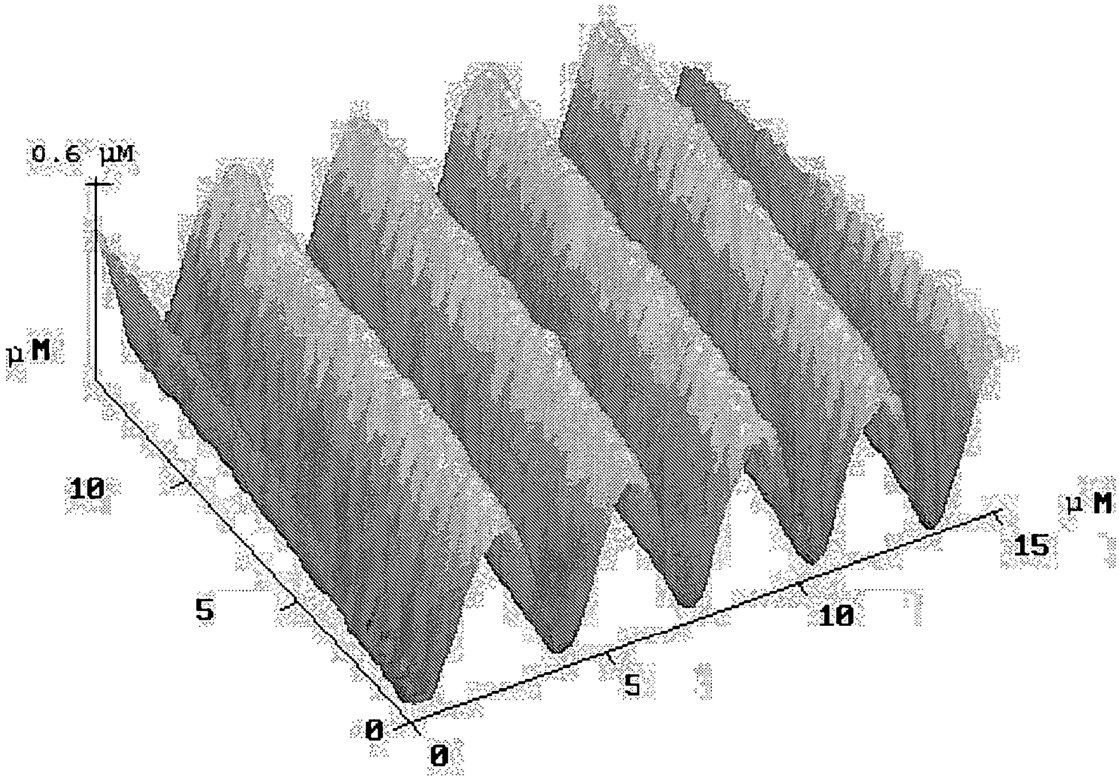
0.6 µM
µM
10
5
0
0
5
10
15
µM

Fig. 1a

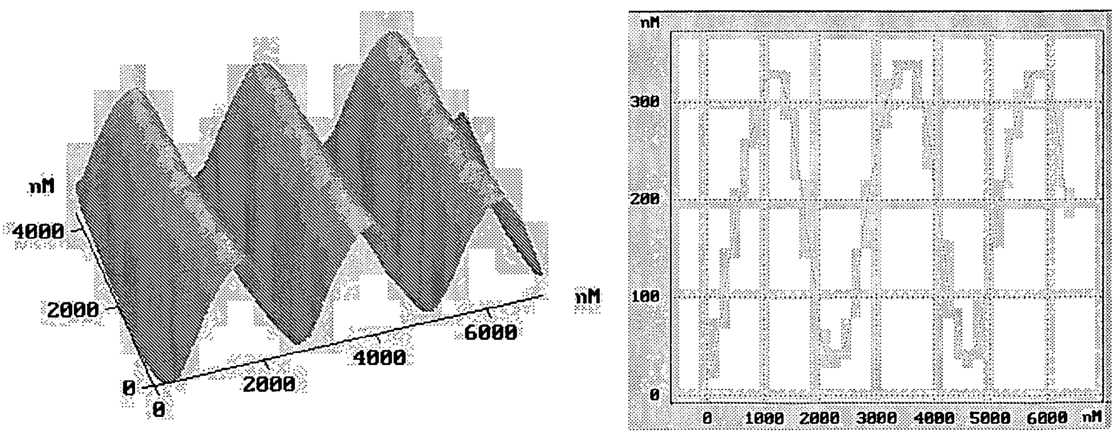
nM
4000
2000
0
0
2000
4000
6000
nM
nM
300
200
100
0
0
1000
2000
3000
4000
5000
6000
nM

Fig. 1b

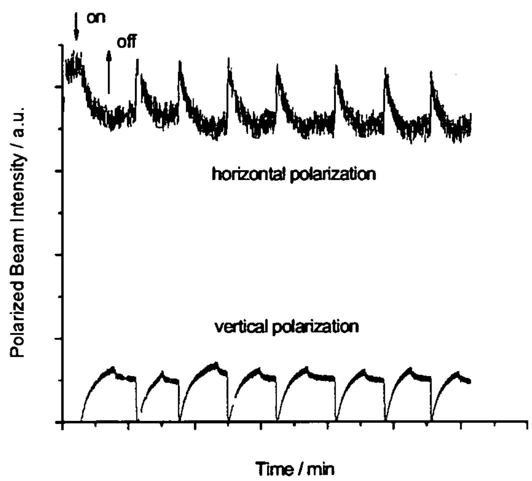


Fig. 2

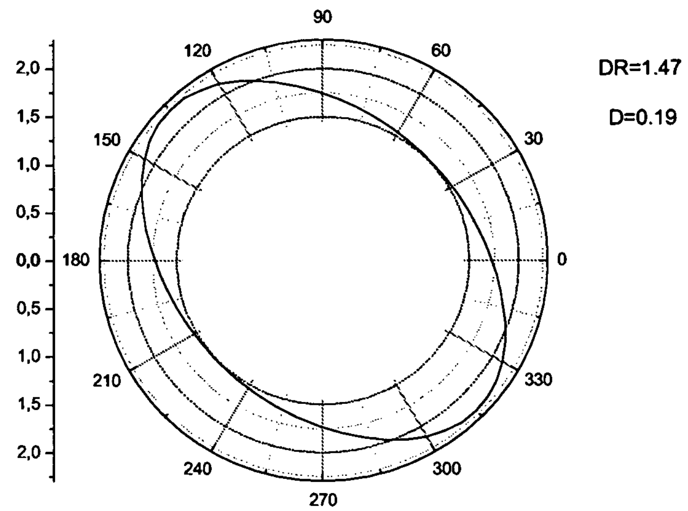


Fig. 3

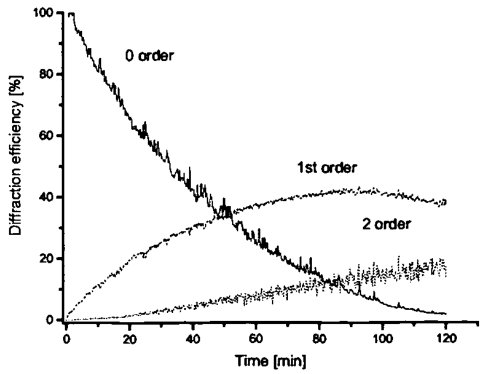


Fig. 4

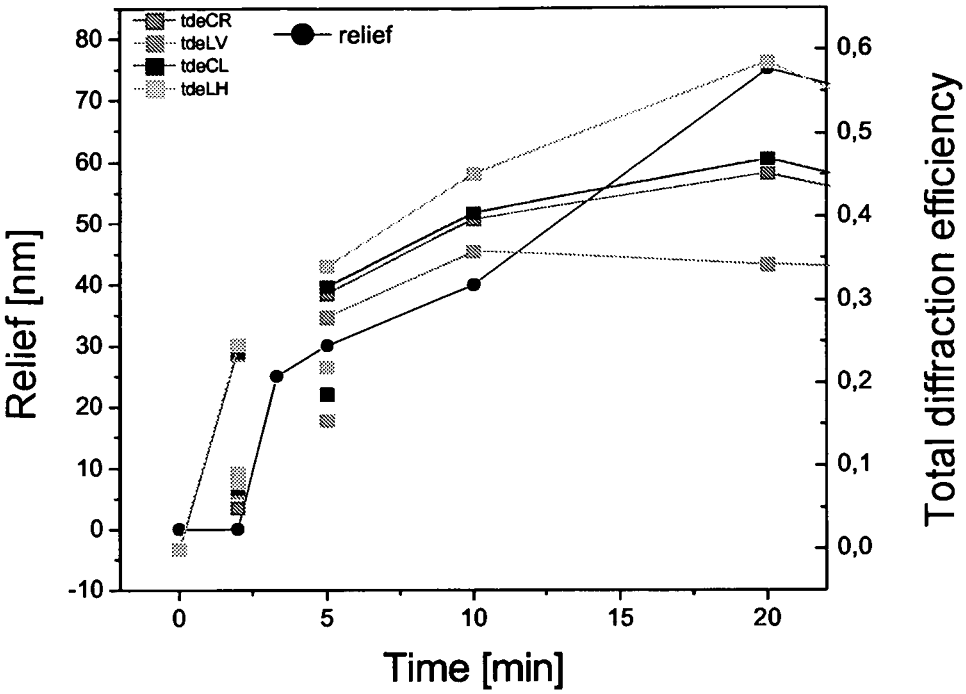
tdeCR
tdeLV
tdeCL
tdeLH
relief
Relief [nm]
Total diffraction efficiency
Time [min]
80
70
60
50
40
30
20
10
0
-10
0,6
0,5
0,4
0,3
0,2
0,1
0,0
0
5
10
15
20

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 9836298 A, X. Jiang


### Non-patent literature cited in the description


- **K.Ichimura.** *Chem. Rev.,* 2000, vol. 100, 1847
- **A. Natansohn et al.** *Chem. Rev.,* 2002, vol. 102, 4139
- **V. Shibaev et al.** *Prog. Polym. Sci.,* 2003, vol. 28, 729-836
- **J. Si et al.** *APPL. PHYS. LETT.,* 2000, vol. 80, 359
- **C. Fiorini et al.** *Synthetic Metals,* 2000, vol. 115, 121-125
- **V. Chigrinov et al.** *1106 • SID 02 DIGEST*
- **V.A. Konovalov et al.** *EURODISPLAY,* 2002, 529
- **W.C.Yip et al.** *Displays,* 2001, vol. 22, 27
- **A. M.-K. Park et al.** *Langmuir,* 2002, vol. 18, 4532
- **Ziegler et al.** *Colloids and Surfaces, A,* 2002, vol. 198-200, 777-784
- **V. Zucolotto et al.** *Polymer,* 2003, vol. 44, 6129-6133
- **N.K. Viswanathan et al.** Surface relief structures on azo polymer films. *J. Mater. Chem.,* 1999, vol. 9, 1941-55
- **G. Wang et al.** *Thin Solid Films,* 2004, vol. 458, 143-148
- **E.B. Barmatov et al.** *Polymer Science, Ser. A,* 2001, vol. 43 (3), 285
- **W. Dawydoff et al.** *Acta Polym.,* 1991, vol. 42, 592
- **A.F. Thunemann et al.** *Macromolecules,* 2000, vol. 32, 7414
- *MACROMOLECULES,* 2000, vol. 33, 5665